# EUROPÄISCHE PATENTSCHRIFT

(11) **EP 2 009 674 B1**
(45) Veröffentlichungstag und Bekanntmachung des Hinweises auf die Patenterteilung: **13.04.2011**
(21) Anmeldenummer: 08104357.2
(22) Anmeldetag: 11.06.2008
(51) Int. Cl.: H01L 21/00, B23K 3/08, B23K 1/20, B23K 3/06

(54) **Vorrichtung zur Herstellung und Präsentation von Flüssigkeitsschichten**
Device for producing and presenting fluid layers
Dispositif de fabrication et de présentation de couches de liquide

(30) Priorität: 27.06.2007 DE 102007029726
(43) Veröffentlichungstag der Anmeldung: 31.12.2008
(73) Patentinhaber: Siemens Electronics Assembly Systems GmbH & Co. KG, 81379 München (DE)
(72) Erfinder: Daschner, Christian, 93413 Cham (DE); Zeiger, Thomas, 6134, Vomp (AT)
(74) Vertreter: Dilg, Haeusler, Schindelmann Patentanwaltsgesellschaft mbH

(56) Entgegenhaltungen:
- EP-A2- 2 009 673
- US-B1- 6 293 317

## Beschreibung

Die vorliegende Erfindung betrifft eine Vorrichtung zur Herstellung und Präsentation von Flüssigkeitsschichten, umfassend,
eine Flüssigkeits-Trägerplatte,
einen Flüssigkeitsbehälter zum Aufbringen einer Flüssigkeitsschicht auf einer Oberfläche der Flüssigkeits-Trägerplatte, und
einen Hubmechanismus mittels welchem die Flüssigkeits-Trägerplatte und der Flüssigkeitsbehälter relativ zueinander verschiebbar sind oder verschoben werden.

Derartige Vorrichtungen sind beispielsweise aus dem Patent US 6,293,317 B1 bekannt. Dieses Patent offenbart einen nach unten geöffneten Flüssigkeitsbehälter zur Aufnahme von Flussmittel, welcher über eine Platte bewegbar ist, die Vertiefungen zur Aufnahme des Flussmittels enthält. Bei einer Bewegung des Behälters über diese Platte tritt durch die untere Öffnung des Flüssigkeitsbehälters Flussmittel aus wobei dann die Vertiefungen in der Platte mit dem Flussmittel gefüllt werden. Danach werden beispielsweise die Kontakte von Halbleiterbauelementen in eine solche gefüllte Vertiefung eingetaucht und so mit Flussmittel benetzt, beispielsweise zum Verlöten mit einer Schaltungsplatine.

Es ist ein Nachteil des genannten Standes der Technik, dass durch die räumliche Ausdehnung des Vorratsbehälters für das Flussmittel die räumliche Zugänglichkeit zu den Vertiefungen unter Umständen schwierig ist, da z.B. der Vorratsbehälter beim Transport eines Bauelements zu der mit Flussmittel gefüllten Platte im Weg ist und umgangen werden muss.

Daher ist es eine Aufgabe der vorliegenden Erfindung, eine Vorrichtung zur Herstellung und Präsentation von Flüssigkeitsschichten zur Verfügung zu stellen, welche eine verbesserte Zugänglichkeit zu den hergestellten Flüssigkeitsschichten aufweist.

Diese Aufgabe wird gelöst von einer Vorrichtung zur Herstellung und Präsentation von Flüssigkeitsschichten, umfassend eine Flüssigkeits-Trägerplatte,
einen Flüssigkeitsbehälter zum Aufbringen einer Flüssigkeitsschicht auf einer Oberfläche der Flüssigkeits-Trägerplatte, und
einen Hubmechanismus, mittels welchem die Flüssigkeits-Trägerplatte und der Flüssigkeitsbehälter relativ zueinander verschiebbar sind oder verschoben werden, wobei die Vorrichtung weiterhin derart ausgebildet und eingerichtet ist,
dass in einer Aufbringstellung des Hubmechanismus der Flüssigkeitsbehälter zum Aufbringen einer Flüssigkeitsschicht über die Flüssigkeits-Trägerplatte bewegbar ist oder bewegt wird und
dass in einer Benetz-Stellung des Hubmechanismus der Flüssigkeitsbehälter in und/oder unterhalb einer Oberflächenebene einer aufgebrachten Flüssigkeitsschicht liegt.

Die vorstehend ausgeführte Ausgestaltung der Aufbring- und Benetz-Stellung bewirkt, dass die Flüssigkeits-Trägerplatte in der Benetz-Stellung gegenüber der Flüssigkeits-Trägerplatte im Vergleich zur Aufbring-Stellung erhöht angeordnet ist. Dadurch verringert sich beim Zugang zur Oberflächenebene die räumlich Barriere, die durch den Flüssigkeitsbehälter gebildet wird. Daher muss beispielsweise ein in die Flüssigkeitsschicht einzutauchendes Bauelement zum Anheben über den Flüssigkeitsbehälter weniger angehoben bzw. abgesenkt werden. Damit ist dann z.B. eine schnellere Nutzung der Flüssigkeitsschicht möglich oder auch ein geringerer mechanischer Aufwand zur Nutzung der Flüssigkeitsschicht notwendig. Daher wird durch eine Vorrichtung gemäß der vorstehenden Beschreibung die räumliche Zugänglichkeit zur Flüssigkeitsschicht verbessert.

Die Worte "oben" und "unten" bzw. "oberhalb" und "unterhalb" werden im Rahmen der vorliegenden Beschreibung derart verwendet, dass als "unterhalb" der Oberflächenebene einer aufgebrachten Flüssigkeitsschicht der räumliche Bereich verstanden wird, in welchem unter anderem auch die Flüssigkeits-Trägerplatte liegt. Als "oberhalb" der genannten Oberflächenebene wird dann demzufolge der auf der entsprechend anderen Seite liegende räumliche Bereich verstanden.

Die Benetz-Stellung des Hubmechanismus kann dabei derart ausgestaltet sein, dass der Flüssigkeitsbehälter in der Oberflächenebene einer aufgebrachten Flüssigkeitsschicht liegt, wobei die Oberflächenebene den Flüssigkeitsbehälter schneidet und beispielsweise 10 Prozent, 20 Prozent, 50 Prozent, 90 Prozent oder auch 100 Prozent des vom Flüssigkeitsbehälter ausgefüllten Volumens unterhalb der Oberflächenebene liegen.

Mit einer derartigen Vorrichtung verwendbarer Flüssigkeiten können beispielsweise Flussmittel für Lötprozesse, Lotpasten, Kleber, Wärmeleitpasten, elektrische Leitpasten oder auch beliebige andere Flüssigkeiten, insbesondere Flüssigkeiten mit hoher Viskosität, sein.

Die Flüssigkeits-Trägerplatte kann zumindest einen ebenen Bereich zum Aufbringen von Flüssigkeiten umfassen. Sie kann beispielsweise auch mehrere ebene Bereiche, insbesondere mehrere getrennte ebene Bereiche, umfassen. Wenn die Oberfläche der Flüssigkeits-Trägerplatte mehrere ebene Oberflächenbereiche, insbesondere mehrere getrennte ebene Oberflächenbereiche, umfasst, können alle diese Bereiche eine identische Höhenlage oder auch verschiedene Höhenlagen (z.B. zur Herstellung von Schichten mit verschiedenen Dicken in einem Arbeitsgang) aufweisen.

Weiterhin kann die Flüssigkeits-Trägerplatte auch nicht-ebene Bereiche, wie beispielsweise Nuten zur Ableitung von Flüssigkeitsresten aufweisen. Insbesondere kann die Flüssigkeits-Trägerplatte eine im Wesentlichen ebene Platte mit einer im Randbereich der Platte umlaufenden Nut zur Ableitung von Flüssigkeitsresten sein. Weiterhin kann die Flüssigkeits-Trägerplatte als im Wesentlichen ebene Platte mit mindestens einer Vertiefung zur Aufnahme der Flüssigkeiten ausgebildet sein. Im letztgenannten Fall ist dann die "Bodenfläche" der mindestens einen Vertiefung die Oberfläche der Flüssigkeits-Trägerplatte zum Aufbringen der Flüssigkeitsschicht.

Die Oberfläche der Flüssigkeits-Trägerplatte, auf welcher die Flüssigkeitsschicht aufgebracht wird oder worden ist, kann im Wesentlichen eben sein.

Die Verschiebung der Flüssigkeits-Trägerplatte und des Flüssigkeitsbehälters relativ zueinander kann derart erfolgen, dass zumindest eine Komponente der Verschiebungsbewegung senkrecht zur Oberfläche der Flüssigkeits-Trägerplatte ist. Weiterhin kann die Verschiebung insgesamt im Wesentlichen senkrecht zur Oberfläche der Flüssigkeits-Trägerplatte sein. Als Oberfläche wird hierbei der Bereich der Flüssigkeits-Trägerplatte betrachtet, auf welchem die Flüssigkeitsschichten aufbringbar oder aufgebracht sind.

Bei der Vorrichtung können eine oder auch mehrere Aufbringstellungen vorgesehen sein. Dabei kann beispielsweise eine Aufbring-Stellung einer Schichtdicke einer aufzubringenden oder aufgebrachten Flüssigkeitsschicht entsprechen. Eine Aufbringstellung ist allgemein dadurch charakterisiert, dass beim Vorliegen einer Aufbring-Stellung der Flüssigkeitsbehälter zum Aufbringen einer Schicht über die Platte bewegbar ist oder bewegt wird.

Zum Aufbringen einer Flüssigkeitsschicht kann der Flüssigkeitsbehälter beispielsweise parallel zur Oberfläche, bzw. entlang der Oberfläche der Flüssigkeits-Trägerplatte bewegt werden. Die Bewegung kann dabei zumindest über Teile der Flüssigkeits-Trägerplatte erfolgen. Insbesondere kann beim Aufbringen einer Flüssigkeitsschicht der Flüssigkeitsbehälter im Wesentlichen über die gesamte Flüssigkeits-Trägerplatte bewegt werden. Weiterhin kann der Flüssigkeitsbehälter zum Aufbringen einer Flüssigkeitsschicht auch von einer Ausgangsstellung über im Wesentlichen die gesamte Flüssigkeits-Trägerplatte bewegt werden und dann wieder zurück in die Ausgangsstellung gebracht werden.

Dass in der Benetz-Stellung der Flüssigkeitsbehälter in und/oder unterhalb einer Oberflächenebene einer aufgebrachten Flüssigkeitsschicht liegt, bedeutet, dass entweder Teile des Flüssigkeitsbehälters in der Ebene liegen, in der auch die Oberfläche der Flüssigkeitsschicht liegt oder der Flüssigkeitsbehälter unterhalb dieser Ebene liegt.

In einer bevorzugten Ausführungsform der Vorrichtung kann vorgesehen sein, dass alle Bereiche des Flüssigkeitsbehälters in und/oder unterhalb der Oberflächenebene einer aufgebrachten Flüssigkeitsschicht liegen. Dies bedeutet, dass keine Bereiche des Flüssigkeitsbehälters diese Oberflächenebene überragen. Der Flüssigkeitsbehälter kann also beispielsweise mit einer Oberseite noch in der Oberflächenebene liegen, während alle restlichen Bereich des Flüssigkeitsbehälters unterhalb der Oberflächenebene liegen. Weiterhin kann der Flüssigkeitsbehälter auch insgesamt unterhalb der Oberflächenebene einer aufgebrachten Flüssigkeitsschicht liegen. Diese Ausgestaltung hat den Vorteil, dass der Flüssigkeitsbehälter in der Benetz-Stellung des Hubmechanismus für ein in die Flüssigkeit einzutauchendes Element keine Barriere mehr bildet, über welche das Element gegebenenfalls gehoben werden müsste. Daher wird dadurch die räumliche Zugänglichkeit zu einer aufgebrachten Flüssigkeitsschicht weiter verbessert.

Weiterhin kann vorgesehen sein, dass in der Benetz-Stellung insbesondere abgesehen von der Flüssigkeits-Trägerplatte, alle weiteren Bereiche der Vorrichtung in und/oder unterhalb der Oberflächenebene einer aufgebrachten Flüssigkeitsschicht liegen. Insbesondere können in der Benetz-Stellung auch alle Bereiche der Vorrichtung in und/oder unterhalb der Oberflächenebene einer aufgebrachten Flüssigkeitsschicht liegen. In dieser letztgenannten Ausgestaltung überragen dann keine Vorrichtungselemente die Oberflächenebene einer aufgebrachten Flüssigkeitsschicht, wobei die räumliche Zugänglichkeit zur Flüssigkeitsschicht weiter verbessert wird.

Die Vorrichtung kann zudem derart ausgestaltet sein, dass eine Dicke einer aufzubringenden Flüssigkeitsschicht mittels des Hubmechanismus einstellbar ist oder eingestellt wird. Dabei kann die Dicke der aufzubringenden Flüssigkeitsschicht beispielsweise zwischen einem vorgegebenen oder vorgebbaren minimalen und einem vorgegebenen oder vorgebbaren maximalen Dickenwert kontinuierlich einstellbar sein. Eine derart ausgestaltete Vorrichtung hat den Vorteil, dass mittels des Hubmechanismus nicht nur ein Wechsel von der Aufbring-Stellung in die Benetz-Stellung und zurück möglich ist, sondern auch als weitere Funktion des Hubmechanismus die Dicke einer aufzubringenden Flüssigkeitsschicht einstellbar ist. Dies vereinfacht die Herstellung einer solchen Vorrichtung, da der Hubmechanismus zwei unterschiedliche Funktionen erfüllen kann.

Eine kontinuierliche Einstellbarkeit der Dicke einer aufzubringenden Flüssigkeitsschicht zwischen einem minimalen und maximalen Dickenwert ermöglicht die sehr flexible Anpassung der Dicke der Flüssigkeitsschicht an z.B. Bauteile, die beispielsweise in diese Flüssigkeitsschicht eingetaucht werden und/oder mit der Flüssigkeit benetzt werden. Dadurch ist die Vorrichtung besser an mögliche Anwendungen der Flüssigkeitsschichten anpassbar.

Die Dicke einer aufzubringenden Flüssigkeitsschicht kann beispielsweise durch eine Höhendifferenz der Oberfläche der Flüssigkeits-Trägerplatte, auf der die Flüssigkeit aufgebracht wird, und einer Unterkante des Flüssigkeitsbehälters vorgegeben sein. Dies ist insbesondere bei Vorrichtungen anwendbar, bei welchen die Flüssigkeitsbehälter an ihrer Unterseite eine Öffnung aufweisen, aus welcher die Flüssigkeit zum Aufbringen auf der Oberfläche austritt.

Eine aufgebrachte Flüssigkeitsschicht kann beispielsweise teilweise oder auch vollständig durch ihre Oberflächenspannung stabilisiert sein. Weiterhin kann eine aufgebrachte Flüssigkeitsschicht auch teilweise oder vollständig durch eine mechanische Begrenzung (z.B. eine Seitenwand) stabilisiert sein.

Die Flüssigkeits-Trägerplatte kann derart ausgebildet sein, dass sie keine vertikal über die Oberfläche zum Aufbringen der Flüssigkeitsschicht hinausragenden Seitenelemente zur Begrenzung einer aufgebrachten oder aufzubringenden Flüssigkeitsschicht aufweist. Eine solche aufgebrachte Flüssigkeitsschicht wird also z.B. nicht durch Wände begrenzt und/oder befindet sich in einer Vertiefung sondern wird beispielsweise über die Oberflächenspannung der Flüssigkeit zumindest teilweise stabilisiert. Diese Ausgestaltung hat den Vorteil, dass damit vergleichsweise einfach eine kontinuierliche Einstellbarkeit einer aufzubringenden Flüssigkeitsschicht erreichbar ist, da beispielsweise keine Seiten- oder Wandelemente einer bestimmten Höhe die Bewegung des Flüssigkeitsbehälters behindern können.

Weiterhin kann die Flüssigkeits-Trägerplatte auch eine oder mehrere Vertiefungen zur Aufnahme einer Flüssigkeitsschicht aufweisen. Diese Ausgestaltung hat z.B. den Vorteil, dass die Flüssigkeiten sicher in den Vertiefungen gelagert sind und die Flüssigkeitsschicht dadurch stabilisiert wird

Die Vorrichtung kann zudem ein Basiselement umfassen, wobei das Basiselement insbesondere zum Befestigen der Vorrichtung an einen Träger ausgebildet sein kann. Eine derartige Vorrichtung kann beispielsweise auch derart ausgebildet sein, dass sie mittels des Basiselements an einer Basiseinheit eines Bestückautomaten befestigt oder befestigbar ist. Das Basiselement kann beispielsweise ein ganz oder teilweise geschlossenes Gehäuse, eine Träger-Einheit oder auch ein mechanisches Tragegestell oder ein Grundgerüst sein. Mittels eines solchen Basiselements wird eine vereinfachte Integration einer solchen Vorrichtung in ein größeres Produktions-Ensemble, beispielsweise einen Bestückautomaten oder andere Produktionsmaschinen z.B. in der Halbleiter- oder Elektronikfertigung, erreicht.

Der Hubmechanismus kann dabei so ausgestaltet sein, dass bei Betätigung des Hubmechanismus sich die Flüssigkeits-Trägerplatte relativ zum Basiselement bewegt. Weiterhin kann die Vorrichtung derart ausgestaltet sein, dass bei der Betätigung des Hubmechanismus sich der Flüssigkeitsbehälter relativ zum Basiselement bewegt.

Der Hubmechanismus kann beispielsweise als manuell betätigter oder betätigbarer Hubmechanismus ausgestaltet sein.

Weiterhin kann der Hubmechanismus eine Antriebseinheit zur Bewegung der Flüssigkeits-Trägerplatte oder des Flüssigkeitsbehälters umfassen. Die Antriebseinheit kann dabei beispielsweise als Motor, z.B. ein Elektromotor, oder als auch hydraulische oder pneumatische Antriebseinheit ausgebildet sein. Die Antriebseinheit kann, z.B. im Falle eines Motors, beispielsweise relativ zum Basiselement fixiert sein. Ein derart ausgestalteter Hubmechanismus ermöglicht eine vereinfachte Ansteuerung der beschriebenen Vorrichtung.

Weiterhin kann der Hubmechanismus ein durch die Antriebseinheit angetriebenes erstes Antriebselement und ein an der Flüssigkeits-Trägerplatte oder dem Flüssigkeitsbehälter befindliches zweites Antriebselement umfassen, wobei das erste Antriebselement zur Bewegung der Flüssigkeits-Trägerplatte bzw. des Flüssigkeitsbehälters mit dem zweiten Antriebselement zusammenwirkt. So kann das erste Antriebselement beispielsweise als zumindest abschnittsweise keilförmiges Element und das zweite Antriebselement als daran angepasstes, ebenfalls zumindest abschnittsweise keilförmiges Element ausgebildet sein. Diese können beispielsweise derart ausgebildet und zueinander angeordnet sein, dass bei der Bewegung des ersten Antriebselements das zweite Antriebselement im Wesentlichen senkrecht zur Bewegung des ersten Antriebselements bewegt. Antriebselemente können beispielsweise auch Rollen, Räder, Riemen oder ähnliches umfassen. Durch diese Ausgestaltung ergibt sich ein mechanisch einfacher und gut herstellbarer Aufbau.

Weiterhin kann der Hubmechanismus derart ausgebildet sein, dass das erste Antriebselement zur Bewegung der Flüssigkeits-Trägerplatte bzw. des Flüssigkeitsbehälters im Wesentlichen parallel zu der Oberfläche der Flüssigkeits-Trägerplatte bewegt wird oder bewegbar ist.

Das erste und zweite Antriebselement kann jeweils eine winklig zur Oberfläche der Flüssigkeits-Trägerplatte orientierte Gleitfläche aufweisen, wobei die Gleitflächen der Antriebselemente derart angeordnet und ausgestaltet sind, dass sie sich bei einer Bewegung der Flüssigkeits-Trägerplatte durch die Antriebseinheit aneinander vorbei bewegen. Die Gleitflächen können dabei beispielsweise als Gleitlager ausgebildet sein. Weiterhin können auf den Gleitflächen Laufrollen, Führungsschienen und/oder Laufschlitten vorgesehen sein. Durch den genannten Aufbau des Hubmechanismus lässt sich ein Platz sparender Antrieb mit vereinfachtem und gut produzierbarem Aufbau erreichen.

Die vorstehend genannte Aufgabe wird weiterhin erfüllt von einem Bestückautomaten zum Bestücken von elektrischen und/oder optischen Bauteilen auf Substrate, umfassend: einen Greifer zum Aufnehmen von elektrischen und/oder optischen Bauteilen aus einem Zuführbereich des Bestückautomaten und zum Absetzen der Bauteile auf einem Substrat und eine Vorrichtung zur Herstellung und Präsentation von Flüssigkeitsschichten gemäß der vorstehenden Beschreibung, wobei der Bestückautomat derart ausgebildet und eingerichtet ist, dass zumindest Kontaktabschnitte von vom Greifer gehaltenen elektrischen und/oder optischen Bauteile nach dem Aufnehmen der Bauteile aus dem Zuführbereich und vor dem Absetzen auf dem Substrat unter Verwendung der Vorrichtung zur Herstellung und Präsentation von Flüssigkeitsschichten zumindest teilweise mit der Flüssigkeit benetzt werden oder benetzbar sind.

Solche Greifer zum Aufnehmen von elektrischen und/oder optischen Bauteilen können beispielsweise als Saugpipetten oder auch mechanische Greifer ausgebildet sein. Die Benetzung der Bauteile mit der Flüssigkeit der Flüssigkeitsschicht kann beispielsweise derart erfolgen, dass ein vom Greifer gehaltenes Bauelement durch Bewegung des Greifers zumindest teilweise in die Flüssigkeitsschicht eingetaucht wird.

Dadurch, dass die im Bestückautomat verwendete Vorrichtung zur Herstellung und Präsentation von Flüssigkeitsschichten gemäß der vorigen Beschreibung ausgebildet ist, kann auch mit einem derartigen Bestückautomaten beim Einstellen der Benetz-Stellung der Vorrichtung eine vereinfachte räumliche Zugänglichkeit zu einer Flüssigkeitsschicht in der Vorrichtung erreicht werden. Dies kann beispielsweise dadurch gegeben sein, dass in der Benetz-Stellung die Flüssigkeitsschicht relativ zum Flüssigkeitsbehälter und der Aufbring-Stellung angehoben ist und so z.B. der Flüssigkeitsbehälter eine geringere räumliche Barriere beim Transport eines Bauteils zur Flüssigkeitsschicht bilden kann.

Der Bestückautomat kann weiterhin so ausgebildet sein, dass die Vorrichtung zur Herstellung und Präsentation von Flüssigkeitsschichten zumindest teilweise in dem Zuführbereich oder an dem Zuführbereich angrenzend angeordnet ist. Dabei kann die Vorrichtung beispielsweise an dem Bestückautomaten, beispielsweise an einer Basiseinheit des Bestückautomaten, befestigt sein. Weiterhin kann die Vorrichtung auch beispielsweise mit einer Basiseinheit von Zuführelementen verbunden sein. Auf diese Weise wird die räumliche Zugänglichkeit zu den Flüssigkeitsschichten weiter verbessert, da Bauteile, die dem Zuführbereich entnommen werden, nur einen relativ kurzen Weg zurücklegen müssen, wenn sie in die Flüssigkeitsschicht eingetaucht werden sollen.

Die vorstehend genannte Aufgabe wird ebenfalls gelöst von einem Verfahren zur Herstellung und Präsentation einer Flüssigkeitsschicht mit einer Vorrichtung gemäß der vorstehenden Beschreibung, bestehend aus den Schritten:
Einstellen der Aufbring-Stellung mit dem Hubmechanismus, Aufbringen der Flüssigkeitsschicht,
Einstellen der Benetz-Stellung mit dem Hubmechanismus.

Durch das Einstellen der Benetz-Stellung nach dem Aufbringen der Flüssigkeitsschicht wird erreicht, dass zumindest der Flüssigkeitsbehälter eine geringere räumliche Barriere bei der Zufuhr eines mit der Flüssigkeitsschicht zu verwendenden Elements bildet. Daher wird die räumliche Zugänglichkeit der Vorrichtung bei der Verwendung des beschriebenen Verfahrens verbessert.

Weiterhin kann bei dem beschriebenen Verfahren die Aufbring-Stellung derart eingestellt werden, dass durch den Abstand der Unterkante des Flüssigkeitsbehälters zu der Oberfläche der Flüssigkeits-Trägerplatte eine Dicke der aufzubringenden Flüssigkeitsschicht vorgegeben oder vorgebbar ist. Auf diese Weise kann mit dem vorgestellten Verfahren eine Flüssigkeitsschicht mit definierter, z.B. auch kontinuierlich einstellbarer, Dicke hergestellt werden.

Beispielsweise im vorstehend genannten Fall hängt die Dicke der aufzubringenden Flüssigkeitsschicht außer vom Abstand der Unterkante des Flüssigkeitsbehälters zu der Oberfläche der Flüssigkeits-Trägerplatte von weiteren Parametern wie z.B. den physikalisch-chemischen Eigenschaften der Flüssigkeit, wie z.B. Oberflächenspannung und Zähigkeit, und oder von der Ausgestaltung der Flüssigkeits-Trägerplatte ab. Diese zusätzlichen Abhängigkeiten sollen aber im Rahmen der vorliegenden Beschreibung außer Betracht bleiben.

Zum Aufbringen der Flüssigkeitsschicht kann weiterhin beispielsweise der Flüssigkeitsbehälter über die Flüssigkeits-Trägerplatte bewegt werden, z.B. entlang der oder parallel zu der Oberfläche der Flüssigkeits-Trägerplatte. Alternativ kann beispielsweise auch die Flüssigkeits-Trägerplatte unter dem Flüssigkeitsbehälter hindurch bewegt werden. Auf diese Weise kann in vereinfachter Weise eine Flüssigkeitsschicht auf der Flüssigkeits-Trägerplatte erstellt werden.

Weiterhin wird die vorstehend genannte Aufgabe auch gelöst durch ein Verfahren zum Bestücken von elektrischen und/oder optischen Bauteilen unter Verwendung eines Bestückautomaten gemäß der vorstehenden Beschreibung, wobei das Verfahren aus den folgenden Schritten besteht:
Einstellen der Aufbringstellung mit dem Hubmechanismus, Aufbringen der Flüssigkeitsschicht,
Einstellen der Benetz-Stellung mit dem Hubmechanismus, Eintauchen zumindest von Kontaktflächen eines mit dem Greifer aus dem Zuführbereich aufgenommenen Bauelements in die Flüssigkeitsschicht,
Absetzen des Bauelements auf einem zu bestückenden Substrat.

Durch Verwenden der Benetz-Stellung im Rahmen der Verwendung der Flüssigkeitsschicht mit einem zu bestückenden Bauelement ergeben sich auch bei diesem Verfahren die Vorteile, wie sie vorstehend bereits im Rahmen des Verfahrens zur Herstellung und Präsentation einer Flüssigkeitsschicht beschrieben sind.

Auch bei dem Verfahren zum Bestücken von elektrischen und/oder optischen Bauteilen kann die Aufbring-Stellung derart eingestellt werden, dass durch den Abstand der Unterkante des Flüssigkeitsbehälters zu der Oberfläche der Flüssigkeits-Trägerplatte einer Dicke der aufzubringenden Flüssigkeitsschicht vorgegeben oder vorgebbar ist.
Aufgrund der Viskosität der Flüssigkeit und der Benetzung der Flüssigkeit an der Flüssigkeits-Trägerplatte kann die Schichtdicke einer hergestellten Flüssigkeitsschicht unter Umständen kleiner sein als der eingestellt oben beschriebene Abstand zwischen Unterkante des Flüssigkeitsbehälters zu der Oberfläche der Flüssigkeits-Trägerplatte.

Weiterhin kann auch hier zum Aufbringen der Flüssigkeitsschicht der Flüssigkeitsbehälter über die Flüssigkeits-Trägerplatte beziehungsweise die Flüssigkeits-Trägerplatte unter dem Flüssigkeitsbehälter hindurch bewegt werden. Auch hier gelten die gleichen Vorteile und Ausgestaltungsmöglichkeiten wie vorstehend bereits in vergleichbaren Zusammenhang beschrieben.

Weitere bevorzugte Ausführungsformen sind in den Unteransprüchen enthalten.

Im Folgenden wir die Erfindung beispielhaft mit Bezug auf die beiliegenden Figuren erläutert. Es zeigen:
Figur 1: Eine Vorrichtung zum Eintauchen von Bauelementkontakten in Flussmittel in einer Aufbring-Stellung;
Figur 2: Die Vorrichtung zum Eintauchen von Bauelementkontakten in Flussmittel gemäß Figur 1 in einer Benetz-Stellung;
Figur 3: Die Vorrichtung zum Eintauchen von Bauelementkontakten in Flussmittel gemäß Figur 1 und 2 in einer weiteren Benetz-Stellung;
Figur 4: Die Vorrichtung zum Eintauchen von Bauelementkontakten in Flussmittel gemäß den Figuren 1 bis 3 mit einer alternativen Stabilisierung der Flüssigkeitsschicht.

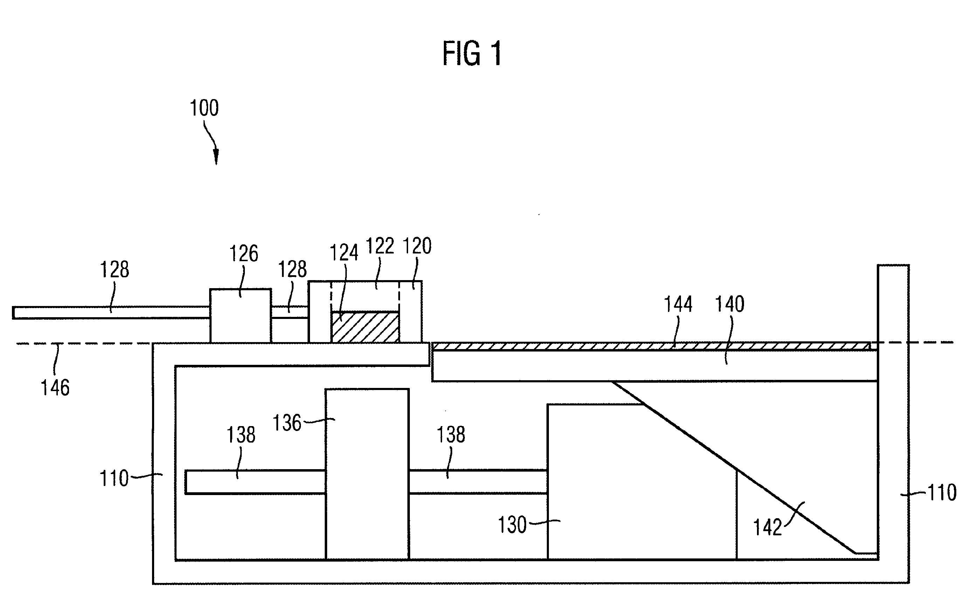

Figur 1 zeigt eine Vorrichtung 100 zum Eintauchen von Bauelementkontakten in Flussmittel, mit welcher eine dünne Flussmittel-Schicht 144 auf einer Flüssigkeits-Trägerplatte 140 hergestellt wurde. Die Vorrichtung 100 umfasst einen Flüssigkeitsbehälter 120, der in einem nach unten geöffneten Speicherbereich 122 einen Vorrat an flüssigem Flussmittel 124 aufbewahrt. Der Flüssigkeitsbehälter 120 ist mittels eines elektrischen Antriebs 126 über eine Schubstange 128 entlang der Oberfläche der Flüssigkeits-Trägerplatte 140 bewegbar. Die Schubstange kann dabei beispielsweise als Gewindestange ausgebildet sein, wobei dann die Antriebseinheit 126 ein entsprechendes Gewinde-Gegenelement beinhalten kann, das von einem entsprechenden Drehantrieb angetrieben wird.

Die Flüssigkeits-Trägerplatte 140 ist höhenverstellbar ausgebildet, wobei die Höhenverstellung über das Zusammenwirken eines an der Flüssigkeitsträgerplatte 140 angebrachten keilförmigen Hub-Elements 142 mit einem mit einer entsprechenden Schräge versehenden Schubelement 130 bewirkt. Das Schubelement 130 ist dabei über eine Antriebseinheit 136 und eine entsprechende Schubstange 138 in Figur 1 horizontal bewegbar. Dabei können der Antrieb 136 und die Schubstange 138 zum Beispiel entsprechend des Antriebs 126 und der Schubstange 128 für den Flüssigkeitsbehälter 120 ausgebildet sein.

Zum Anheben der Flüssigkeits-Trägerplatte 140 kann dann beispielsweise mittels des Antriebs 136 über die Schubstange 138 das Schubelement 130 in Figur 1 nach rechts bewegt werden. Da die Flüssigkeits-Trägerplatte 140 und der daran fixierte Hubkeil 142 in vertikaler Richtung bewegbar gelagert sind, wird die genannte Bewegung des Schubelements 130 über ein aneinander vorbeigleiten der sich berührenden Flächen des Schubelements 130 und des Hubelements 142 in eine Hebebewegung des Hubelements 142 und der damit verbundenen Flüssigkeits-Trägerplatte 140 umgeformt. Auf diese Weise lässt sich durch eine vertikale Bewegung des Schubelements 130 die Flüssigkeits-Trägerplatte 140 vertikal aufwärts und abwärts bewegen.

Im dargestellten Ausführungsbeispiel umfasst ein Hubmechanismus gemäß der vorangegangenen Beschreibung z.B. das Hubelement 142, das Schubelement 130 sowie die Antriebseinheit 136 und die Schubstange 138. Dabei wäre dann beispielsweise das Schubelement 130 ein mögliches erstes Antriebselement gemäß der vorstehenden Beschreibung und das Hubelement 142 eine Möglichkeit eines zweiten Antriebselements gemäß der vorstehenden Beschreibung.

Weiterhin umfasst die Vorrichtung zum Eintauchen von Bauelementen in Flussmittel 100 eine Tragekonstruktion 110, an welcher sowohl die Antriebseinheit 126 für den Flüssigkeitsbehälter 120 als auch die Antriebseinheit 136 für das Schubelement 130 fixiert sind. Damit ist im Falle der in Figur 1 dargestellten Vorrichtung 100 die Flüssigkeits-Trägerplatte 140 relativ zur Tragekonstruktion 110 in vertikaler Richtung bewegbar. Der Flüssigkeitsbehälter 120 ist relativ zur Tragekonstruktion 110 in horizontaler Richtung bewegbar.

Zum Aufbringen der Flüssigkeitsschicht 144 auf der Flüssigkeits-Trägerplatte 140 wird dann mittels des Schubelements 130 über die Antriebseinheit 136 ein Abstand der Oberfläche der Flüssigkeitsträgerplatte 140 zu einer Unterkante des Flüssigkeitsbehälters 120 derart eingestellt, dass durch den Abstand die aufzubringenden Schichtdicke der Flüssigkeitsschicht 144 vorgegeben ist. Danach wird der Flüssigkeitsbehälter 120 mittels seiner Antriebseinheit 126 horizontal über die Flüssigkeits-Trägerplatte 140 geführt, wobei das Flussmittel 124 aus der unteren Öffnung des Vorratsbereichs 122 des Vorratsbehälters austritt. Durch die Bewegung des Flüssigkeitsbehälters 120 über die Flüssigkeits-Trägerplatte 140 bildet sich dann die Flüssigkeitsschicht 144 aus Flussmittel. Nach dem Zurückziehen des Flüssigkeitsbehälters 120 in die in Figur 1 dargestellte Ausgangsstellung ist die Flüssigkeitsschicht 144 aus Flussmittel bereit zur Verwendung.

Die in Figur 1 dargestellte Flüssigkeits-Trägerplatte 140 weist keine vertikalen Begrenzungen für die Flussmittelschicht 144 auf, so dass die Flussmittelschicht 144 alleine durch ihre Oberflächenspannung stabilisiert wird.

In Figur 1 ist eine Möglichkeit einer Aufbring-Stellung des Hubmechanismus 130, 136, 138, 142 dargestellt, wobei eine Oberflächenebene 146 der aufgebrachten Flüssigkeitsschicht 144 sich gerade unterhalb des Flüssigkeitsbehälters 120 befindet.

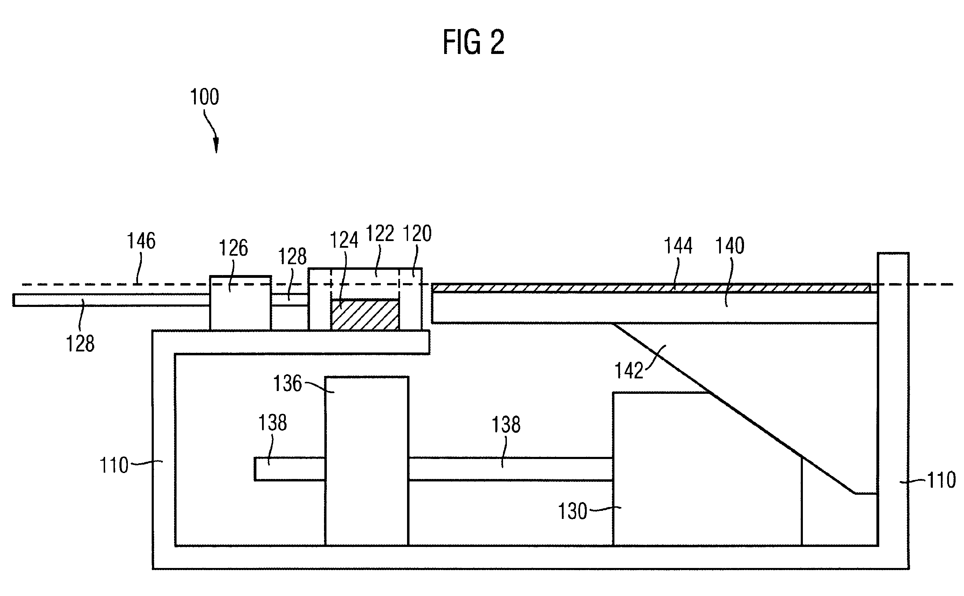

In Figur 2 ist die in Figur 1 dargestellt Vorrichtung zur Herstellung von Flussmittelschichten 100 in einer Benetz-Stellung dargestellt. Die vorstehend bezüglich Figur 1 beschriebenen Bezugszeichen entsprechen denjenigen in Figur 2.

In der in Figur 2 dargestellten Benetz-Stellung der Vorrichtung 100 ist über eine Bewegung des Schubteils 130 nach rechts und eine daraus resultierende Bewegung der Flüssigkeits-Trägerplatte 140 diese derart angehoben, dass Teile des Flüssigkeitsbehälters 120 unterhalb der Oberflächenebene 146 der aufgebrachten Flüssigkeitsschicht 144 liegen. In der in Figur 2 dargestellten Benetz-Stellung der Vorrichtung 100 liegt der Flüssigkeitsbehälter 120 also in der Oberflächenebene 146 der Flüssigkeitsschicht 144. Dabei liegen in dem dargestellten Fall wesentliche Teile, d.h. mehr als 50 % des vom Flüssigkeitsbehälter 120 ausgefüllten Volumens unterhalb der Oberflächenebene 146.

Durch die in Figur 2 dargestellte Benetz-Stellung muss ein beispielsweise in Figur 2 von links kommendes von einem Greifer gehaltenes Bauelement, das in die Flüssigkeitsschicht 144 eingetaucht werden soll, hinter dem Flüssigkeitsbehälter 120 weniger weit abgesenkt werden, um in die Flüssigkeitsschicht 144 eingetaucht zu werden, als wenn die Flüssigkeits-Trägerplatte 140 in der in beispielsweise in Figur 1 dargestellten Aufbring-Stellung verblieben wäre. Dadurch geht das Eintauchen des Bauelements in die Flussmittelschicht 144 schneller, da sie durch das Anheben der Flüssigkeits-Trägerplatte 140 räumlich einfacher und schneller zugänglich ist.

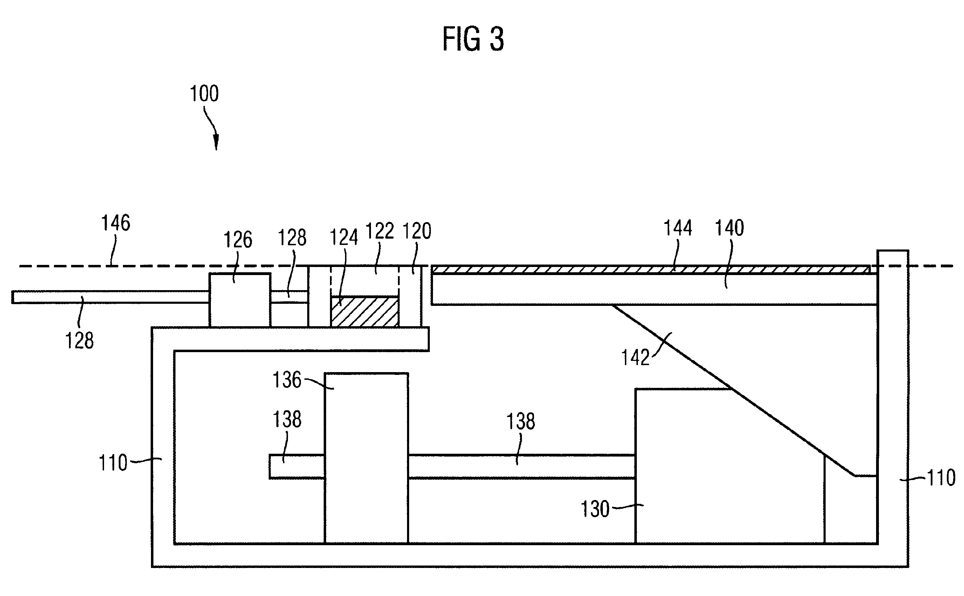

In Figur 3 ist eine weitere Möglichkeit einer Benetz-Stellung der in Figur 1 und 2 dargestellten Vorrichtung 100 zum Herstellen einer Flussmittelschicht 100 dargestellt. In der dargestellten Ausgestaltung ist die Flüssigkeits-Trägerplatte 140 über den Hubmechanismus 130, 136, 138, 142 soweit angehoben, dass alle Bereiche des Flüssigkeitsbehälters 120 in oder unterhalb der Oberflächenebene 146 der aufgebrachten Flussmittelschicht 144 liegen. Das heißt, kein Bereich des Flüssigkeitsbehälters 120 ragt über die Oberflächenebene 146 hinaus. Damit muss eine Bauelement, welches beispielsweise, von einem Greifer gehalten, von links in Figur 3 an die Flussmittelschicht 144 herangeführt wird, vor dem Beginn des Eintauchvorgangs in die Flussmittelschicht 144 nicht weiter abgesenkt werden. Daher wird durch die in Figur 3 dargestellte Benetz-Stellung die räumliche Zugänglichkeit der Flussmittelschicht 144 für ein einzutauchendes Bauelement weiter verbessert.

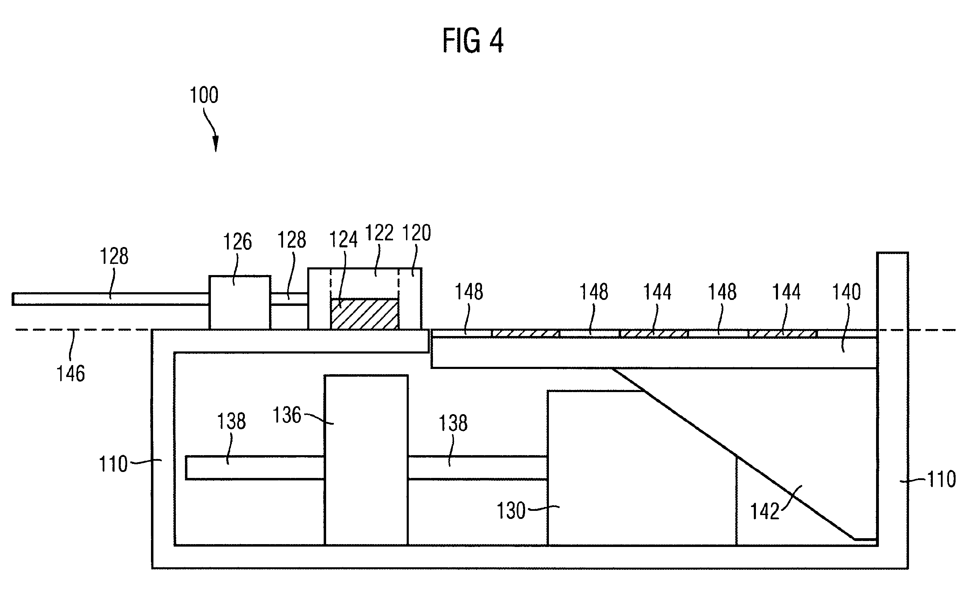

Figur 4 zeigt eine weitere Ausgestaltung für eine Stabilisierung der Flüssigkeitsschicht 144 auf der Flüssigkeits-Trägerplatte 140 der in den Figuren 1 bis 3 dargestellten Vorrichtung zur Herstellung von Flussmittelschichten 100. Dabei ist auf der Flüssigkeits-Trägerplatte 140 eine Platte 148 mit Öffnungen aufgebracht, so dass nach einer Bewegung des Vorratsbehälters 120 für das Flussmittel 124 über die Oberfläche der Lochplatte 148 in den Öffnungen der Lochplatte 148 die Flüssigkeitsschicht 144 hergestellt wurde. Dabei wird die Dicke der Flüssigkeitsschicht 144 im Wesentlichen durch die Dicke der Lochplatte 148 gegeben. Aus Übersichtlichkeitsgründen sind in Figur 4 nicht alle Elemente der Lochplatte 148 sowie der Flüssigkeitsschicht 144 mit einem entsprechenden Bezugszeichen versehen.

In der in Figur 4 dargestellten Ausführungsform kann der Verlust an Flussmittel reduziert werden, da beim Aufbringen und späteren Präsentieren der Flüssigkeitsschicht 144 Flüssigkeitsverluste durch seitliches Ablaufen von Flussmittel, insbesondere in den Randbereichen der Flüssigkeitsschicht 144, stark eingeschränkt oder sogar vermieden werden.

Die vorliegende Erfindung beschreibt eine Vorrichtung zur Herstellung und Präsentation von Flüssigkeitsschichten, wobei durch eine nach dem Aufbringen der Flüssigkeitsschicht einstellbare Benetz-Stellung eine vereinfachte, bessere und schnellere Zugänglichkeit der hergestellten Flüssigkeitsschicht für z.B. ein mit der Flüssigkeitsschicht zu verwendendes Element, erreicht wird.

## Patentansprüche

1. Vorrichtung (100) zur Herstellung und Präsentation von Flüssigkeitsschichten, umfassend
- eine Flüssigkeits-Trägerplatte (140),
- einen Flüssigkeitsbehälter (120) zum Aufbringen einer Flüssigkeitsschicht (144) auf einer Oberfläche der Flüssigkeits-Trägerplatte (140), und
- einen Hubmechanismus (130, 136, 138, 142), mittels welchem die Flüssigkeits-Trägerplatte (140) und der Flüssigkeitsbehälter (120) relativ zueinander verschiebbar sind oder verschoben werden,
**dadurch gekennzeichnet,**
**dass** die Vorrichtung (100) derart ausgebildet und eingerichtet ist,
- **dass** in einer Aufbringstellung des Hubmechanismus (130, 136, 138, 142) der Flüssigkeitsbehälter (120) zum Aufbringen einer Flüssigkeitsschicht (144) über die Flüssigkeits-Trägerplatte (140) bewegbar ist oder bewegt wird, und
- **dass** in einer Benetz-Stellung des Hubmechanismus (130, 136, 138, 142) der Flüssigkeitsbehälter (120) in und/oder unterhalb einer Oberflächenebene (146) einer aufgebrachten Flüssigkeitsschicht (144) liegt.

2. Vorrichtung gemäß Anspruch 1,
**dadurch gekennzeichnet,**
**dass** alle Bereiche des Flüssigkeitsbehälters (120) in und/oder unterhalb der Oberflächenebene (146) einer aufgebrachten Flüssigkeitsschicht (144) liegen.

3. Vorrichtung gemäß Anspruch 1 oder 2,
**dadurch gekennzeichnet,**
**dass** in der Benetz-Stellung abgesehen von der Flüssigkeits-Trägerplatte (140) alle weiteren Bereiche der Vorrichtung (100) in und/oder unterhalb der Oberflächenebene (146) einer aufgebrachten Flüssigkeitsschicht (144) liegen.

4. Vorrichtung gemäß einem der Ansprüche 1 bis 3,
**dadurch gekennzeichnet,**
**dass** eine Dicke einer aufzubringenden Flüssigkeitsschicht (144) mittels des Hubmechanismus (130, 136, 138, 142) einstellbar ist oder eingestellt wird.

5. Vorrichtung gemäß einem der Ansprüche 1 bis 4,
**dadurch gekennzeichnet,**
**dass** die Dicke einer aufzubringenden Flüssigkeitsschicht (144) mittels des Hubmechanismus zwischen einem vorgegebenen oder vorgebbaren minimalen und maximalen Dickenwert kontinuierlich einstellbar ist oder eingestellt wird.

6. Vorrichtung gemäß einem der Ansprüche 1 bis 5,
**dadurch gekennzeichnet,**
**dass** die Flüssigkeits-Trägerplatte (140) keine vertikal über die Oberfläche hinausragenden Seitenelemente zur Begrenzung einer aufgebrachten oder aufzubringenden Flüssigkeitsschicht (144) aufweist.

7. Vorrichtung gemäß einem der Ansprüche 1 bis 5,
**dadurch gekennzeichnet,**
**dass** die Flüssigkeits-Trägerplatte (140) mindestens eine Vertiefung zur Aufnahme einer Flüssigkeitsschicht (144) aufweist.

8. Vorrichtung gemäß einem der Ansprüche 1 bis 7,
**dadurch gekennzeichnet,**
**dass** die Vorrichtung ein Basiselement (110), insbesondere zum Befestigen der Vorrichtung an einem Träger oder einer Basiseinheit eines Bestückautomaten, umfasst.

9. Vorrichtung gemäß einem der Ansprüche 1 bis 8,
**dadurch gekennzeichnet,**
**dass** der Hubmechanismus (130, 136, 138, 142) eine Antriebseinheit (136) zur Bewegung der Flüssigkeits-Trägerplatte (140) umfasst.

10. Vorrichtung gemäß Anspruch 9,
**dadurch gekennzeichnet,**
**dass** der Hubmechanismus (130, 136, 138, 142) weiterhin ein durch die Antriebseinheit (136) angetriebenes erstes Antriebselement (130) und ein an der Flüssigkeits-Trägerplatte (140) befindliches zweites Antriebselement (142) umfasst,
wobei das erste Antriebselement (130) zur Bewegung der Flüssigkeits-Trägerplatte (140) mit dem zweiten Antriebeselement (142) zusammenwirkt.

11. Vorrichtung gemäß Anspruch 10,
**dadurch gekennzeichnet,**
**dass** das erste Antriebselement (130) zur Bewegung der Flüssigkeits-Trägerplatte (140) im Wesentlichen parallel zu der Oberfläche der Flüssigkeits-Trägerplatte (140) bewegt wird oder bewegbar ist.

12. Vorrichtung gemäß Anspruch 10 oder 11,
**dadurch gekennzeichnet,**
**dass** das erste und zweite Antriebselement (130, 142) jeweils eine winklig zur Oberfläche der Flüssigkeits-Trägerplatte (140) orientierte Gleitfläche aufweist, wobei die Gleitflächen der Antriebselemente (130, 142) derart angeordnet und ausgestaltet sind, dass sie sich bei einer Bewegung der Flüssigkeits-Trägerplatte (140) durch die Antriebseinheit (136) aneinander vorbei bewegen.

13. Bestückautomat zum Bestücken von elektrischen und/oder optischen Bauteilen auf Substrate, umfassend
- einen Greifer zum Aufnehmen von elektrischen und/oder optischen Bauteilen aus einem Zuführbereich des Bestückautomaten und zum Absetzen der Bauteile auf einem Substrat, und
- eine Vorrichtung (100) zur Herstellung und Präsentation von Flüssigkeitsschichten gemäß einem der Ansprüche 1 bis 12,
wobei der Bestückautomat derart ausgebildet und eingerichtet ist, dass zumindest Kontaktabschnitte der Bauteile nach dem Aufnehmen der Bauteile aus dem Zuführbereich und vor dem Absetzen auf dem Substrat unter Verwendung der Vorrichtung (100) zur Herstellung und Präsentation von Flüssigkeitsschichten mit der Flüssigkeit benetzt werden oder benetzbar sind.

14. Bestückautomat gemäß Anspruch 13,
**dadurch gekennzeichnet,**
**dass** die Vorrichtung (100) zur Herstellung und Präsentation von Flüssigkeitsschichten zumindest teilweise in dem Zuführbereich oder an den Zuführbereich angrenzend angeordnet ist.

15. Verfahren zur Herstellung und Präsentation einer Flüssigkeitsschicht mit einer Vorrichtung (100) gemäß einem der Ansprüche 1 bis 12, bestehend aus den Schritten:
- einstellen der Aufbringstellung mit dem Hubmechanismus,
- aufbringen der Flüssigkeitsschicht (144),
- einstellen der Benetz-Stellung mit dem Hubmechanismus (130, 136, 138, 142).

16. Verfahren gemäß Anspruch 15,
**dadurch gekennzeichnet,**
**dass** die Aufbringstellung derart eingestellt wird, dass durch den Abstand einer Unterkante des Flüssigkeitsbehälters (120) zu der Oberfläche der Flüssigkeits-Trägerplatte (140) eine Dicke der aufzubringenden Flüssigkeitsschicht (144) vorgegeben oder vorgebbar ist.

17. Verfahren gemäß Anspruch 15 oder 16,
**dadurch gekennzeichnet,**
**dass** zum Aufbringen der Flüssigkeitsschicht (144) der Flüssigkeitsbehälter (120) über die Flüssigkeits-Trägerplatte (140) bewegt wird.

18. Verfahren zum Bestücken von elektrischen und/oder optischen Bauteilen unter Verwendung eines Bestückautomaten gemäß Anspruch 13 oder 14, bestehend aus den Schritten:
- einstellen der Aufbringstellung mit dem Hubmechanismus (130, 136, 138, 142),
- aufbringen der Flüssigkeitsschicht (144),
- einstellen der Benetz-Stellung mit dem Hubmechanismus (130, 136, 138, 142),
- eintauchen zumindest von Kontaktflächen eines mit dem Greifer aus dem Zuführbereich aufgenommenen Bauelements in die Flüssigkeitsschicht (144),
- absetzen des Bauelements auf einem zu bestückenden Substrat.

19. Verfahren gemäß Anspruch 18,
**dadurch gekennzeichnet,**
**dass** die Aufbringstellung derart eingestellt wird, dass durch den Abstand einer Unterkante des Flüssigkeitsbehälters (120) zu der Oberfläche der Flüssigkeits-Trägerplatte (140) eine Dicke der aufzubringenden Flüssigkeitsschicht (144) vorgegeben oder vorgebbar ist.

20. Verfahren gemäß Anspruch 18 oder 19,
**dadurch gekennzeichnet,**
**dass** zum Aufbringen der Flüssigkeitsschicht (144) der Flüssigkeitsbehälter (120) über die Flüssigkeits-Trägerplatte (140) bewegt wird.

## Claims

1. An apparatus (100) for the production and presentation of fluid layers, comprising
- a fluid carrier plate (140),
- a fluid container (120) for applying a fluid layer (144) to a surface of the fluid carrier plate (140), and
- a lifting mechanism (130, 136, 138, 142), by means of which the fluid carrier plate (140) and fluid container (120) are able to be displaced or are displaced relative to each other,
**characterised in that**
the apparatus (100) is embodied and configured so that,
- in an application position of the lifting mechanism (130, 136, 138, 142) the fluid container (120) is able to be moved or is moved to apply a layer of fluid (144) over the fluid carrier plate (140), and
- that, in a wetting position of the lifting mechanism (130, 136, 138, 142), the fluid container (120) lies in and/or below a surface plane (146) of an applied fluid layer (144).

2. Apparatus according to claim 1,
**characterised in that**
all areas of the fluid container (120) lie in and/or below the surface plane (146) of an applied fluid layer (144).

3. Apparatus according to claim 1 or 2,
**characterised in that**,
in the wetting position, apart from the fluid carrier plate (140), all further areas of the apparatus (100) lie in and/or below the surface plane (146) of an applied fluid layer (144).

4. Apparatus according to one of claims 1 to 3,
**characterised in that**
a thickness of a fluid layer to be applied (144) is able to be set or is set by means of the lifting mechanism (130, 136, 138, 142).

5. Apparatus according to one of claims 1 to 4,
**characterised in that**
the thickness of a fluid layer to be applied (144) is able to be set or is set by means of the lifting mechanism (130, 136, 138, 142) continuously between a prespecified or prespecifiable minimum and maximum thickness value.

6. Apparatus according to one of claims 1 to 5,
**characterised in that**
the fluid carrier plate (140) does not have any side elements projecting vertically above the surface to restrict a fluid layer (144) applied or to be applied.

7. Apparatus according to one of claims 1 to 5,
**characterised in that**
the fluid carrier plate (140) features at least one recess to accept a fluid layer (144).

8. Apparatus according to one of claims 1 to 7,
**characterised in that**
the apparatus comprises a base element (110), especially to attach the apparatus to a carrier or a base unit of an automatic component placement device.

9. Apparatus according to one of claims 1 to 8,
**characterised in that**
the lifting mechanism (130, 136, 138, 142) comprises a drive unit (136) for moving the fluid carrier plate (140).

10. Apparatus according to claim 9,
**characterised in that**
the lifting mechanism (130, 136, 138, 142) further comprises a first drive element (130) driven by the drive unit (136) and a second drive element (142) located on the fluid carrier plate (140),
wherein the first drive element (130) interacts with the second drive element (142) to move the fluid carrier plate (140).

11. Apparatus according to claim 10,
**characterised in that**
the first drive element (130), to move the fluid carrier plate (140), is moved or is able to be moved substantially in parallel to the surface of the fluid carrier plate (140).

12. Apparatus according to claim 10 or 11,
**characterised in that**
the first and second drive element (130, 142) each feature a sliding surface arranged inclined at an angle to the surface of the fluid carrier plate (140), with the sliding surfaces of the drive elements (130, 142) being arranged and embodied such that they move past one another when the fluid carrier plate (140) is moved by the drive unit (136).

13. An automatic component placement device for the placement of electrical and/or optical components on substrates, comprising
- a gripper for picking up electrical and/or optical components from a feed area of the automatic component placement device and for placing the components on a substrate, and
- an apparatus (100) for production and presentation of fluid layers according to one of claims 1 to 12,
wherein the automatic component placement device is embodied and configured such that at least contact sections of the components are wetted with the fluid for production and presentation of fluid layers using the apparatus (100) after the components are picked up from the feed area and before they are placed on the substrate.

14. Automatic component placement device according to claim 13,
**characterised in that**
the apparatus (100) for production and presentation of fluid layers is arranged at least partly in the feed area or adjacent to the feed area.

15. Method for production and presentation of a fluid layer with an apparatus (100) according to one of claims 1 to 12, comprising the following steps:
- setting the application position with the lifting mechanism,
- applying the fluid layer (144),
- setting the wetting position with the lifting mechanism (130, 136, 138, 142).

16. Method according to claim 15,
**characterised in that**
the application position is set such that a thickness of the fluid layer (144) to be applied is prespecified by the distance between a lower edge of the fluid container (120) and the surface of the fluid carrier plate (140).

17. Method according to claim 15 or 16,
**characterised in that**
the fluid container (120) is moved over the fluid carrier plate (140) in order to apply the fluid layer (144).

18. Method for picking and placing electronic or optical components using an automatic component placement device according to claim 13 or 14, consisting of the steps:
- setting the application position with the lifting mechanism (130, 136, 138, 142),
- applying the fluid layer (144),
- setting the wetting position with the lifting mechanism (130, 136, 138, 142),
- dipping at least contact surfaces of a component picked up with the gripper from the feed area into the fluid layer (144),
- placing the component on a substrate to be equipped.

19. Method according to claim 18,
**characterised in that**
the application position is set such that a thickness of the fluid layer (144) to be applied is prespecified by the space between a lower edge of the fluid container (120) and the surface of the fluid carrier plate (140).

20. Method according to claim 18 or 19,
**characterised in that**
the fluid container (120) is moved over the fluid carrier plate (140) in order to apply the fluid layer (144).

## Revendications

1. Dispositif (100) de fabrication et de présentation de couches de liquide, comprenant
- une plaque support de liquide (140),
- un réservoir de liquide (120) pour appliquer une couche de liquide (144) sur une surface de la plaque support de liquide (140), et
- un mécanisme de levage (130, 136, 138, 142), au moyen duquel la plaque support de liquide (140) et le réservoir de liquide (120) peuvent se décaler, ou sont décalés l'un par rapport à l'autre,
**caractérisé en ce que**
le dispositif (100) est réalisé et adapté de telle façon
- qu'en position d'application du mécanisme de levage (130, 136, 138, 142), le réservoir de liquide (120) pour appliquer une couche de liquide (144) peut se déplacer, ou est déplacé au-dessus de la plaque support de liquide (140), et
- qu'en position d'humectage du mécanisme de levage (130, 136, 138, 142), le réservoir de liquide (120) est situé dans et/ou au-dessous d'un plan de surface (146) d'une couche de liquide (144) appliquée.

2. Dispositif selon la revendication 1,
**caractérisé en ce que**
toutes les zones du réservoir de liquide (120) sont situées dans et/ou au-dessous du plan de surface (146) d'une couche de liquide (144) appliquée.

3. Dispositif selon la revendication 1 ou 2,
**caractérisé en ce que**
en position d'humectage, à l'exception de la plaque support de liquide (140), toutes les autres zones du dispositif (100) sont situées dans et/ou au-dessous du plan de surface (146) d'une couche de liquide (144) appliquée.

4. Dispositif selon l'une des revendications 1 à 3,
**caractérisé en ce que**
une épaisseur d'une couche de liquide (144) à appliquer peut être réglée, ou est réglée au moyen du mécanisme de levage (130, 136, 138, 142).

5. Dispositif selon l'une des revendications 1 à 4,
**caractérisé en ce que**
l'épaisseur d'une couche de liquide (144) à appliquer peut être réglée, ou est réglée continuellement au moyen du mécanisme de levage entre une valeur d'épaisseur minimale et maximale prédéterminée ou prédéterminable.

6. Dispositif selon l'une des revendications 1 à 5,
**caractérisé en ce que**
la plaque support de liquide (140) est dépourvue d'éléments latéraux dépassant verticalement la surface pour limiter une couche de liquide (144) appliquée ou à appliquer.

7. Dispositif selon l'une des revendications 1 à 5,
**caractérisé en ce que**
la plaque support de liquide (140) présente au moins un creux de réception d'une couche de liquide (144).

8. Dispositif selon l'une des revendications 1 à 7,
**caractérisé en ce que**
le dispositif comprend un élément de base (110), notamment pour fixer le dispositif sur un support ou une unité de base d'un automate d'équipement.

9. Dispositif selon l'une des revendications 1 à 8,
**caractérisé en ce que**
le mécanisme de levage (130, 136, 138, 142) comprend une unité d'entraînement (136) permettant le mouvement de la plaque support de liquide (140).

10. Dispositif selon la revendication 9,
**caractérisé en ce que**
le mécanisme de levage (130, 136, 138, 142) comprend en outre un premier élément d'entraînement (130) entraîné par l'unité d'entraînement (136), et un second élément d'entraînement (142) situé sur la plaque support de liquide (140),
le premier élément d'entraînement (130) coopérant avec le second élément d'entraînement (142) pour permettre le mouvement de la plaque support de liquide (140).

11. Dispositif selon la revendication 10,
**caractérisé en ce que**
pour permettre le mouvement de la plaque support de liquide (140), le premier élément d'entraînement (130) est déplacé, ou peut se déplacer sensiblement parallèlement à la surface de la plaque support de liquide (140).

12. Dispositif selon la revendication 10 ou 11,
**caractérisé en ce que**
le premier et second éléments d'entraînement (130, 142) présentent chacun une surface de glissement d'orientation angulaire par rapport à la surface de la plaque support de liquide (140), les surfaces de glissement des éléments d'entrainement (130, 142) étant disposées et configurées de telle façon qu'elles se déplacent l'une devant l'autre lors d'un mouvement de la plaque support de liquide (140) provoqué par l'unité d'entraînement (136).

13. Automate d'équipement pour placer des composants électriques et/ou optiques sur des substrats, comprenant
- une pince destinée à saisir des composants électriques et/ou optiques dans une zone d'alimentation dudit automate d'équipement et à déposer les composants sur un substrat, et
- un dispositif (100) de fabrication et de présentation de couches de liquide selon l'une des revendications 1 à 12, ledit automate d'équipement étant réalisé et adapté de telle façon que, après avoir saisi les composants dans la zone d'alimentation et avant de les déposer sur le substrat, au moins des portions de contacts desdits composants soient humectées, ou puissent être humectées avec le liquide au moyen du dispositif (100) de fabrication et de présentation de couches de liquide.

14. Automate d'équipement selon la revendication 13,
**caractérisé en ce que**
le dispositif (100) de fabrication et de présentation de couches de liquide est disposé, au moins partiellement, dans la zone d'alimentation ou aux confins de la zone d'alimentation.

15. Procédé de fabrication et de présentation d'une couche de liquide au moyen d'un dispositif (100) selon l'une des revendications 1 à 12, comprenant les étapes :
- régler la position d'application au moyen du mécanisme de levage,
- appliquer la couche de liquide (144),
- régler la position d'humectage au moyen du mécanisme de levage (130, 136, 138, 142).

16. Procédé selon la revendication 15,
**caractérisé en ce que**
on règle la position d'application de telle façon qu'une épaisseur de la couche de liquide (144) à appliquer est prédéterminée, ou prédéterminable par la distance d'un bord inférieur du réservoir de liquide (120) par rapport à la surface de la plaque support de liquide (140).

17. Procédé selon la revendication 15 ou 16,
**caractérisé en ce que**
pour appliquer la couche de liquide (144), on déplace le réservoir de liquide (120) au-dessus de la plaque support de liquide (140).

18. Procédé pour placer des composants électriques et/ou optiques au moyen d'un automate d'équipement selon la revendication 13 ou 14, comprenant les étapes :
- régler la position d'application au moyen du mécanisme de levage (130, 136, 138, 142),
- appliquer la couche de liquide (144),
- régler la position d'humectage au moyen du mécanisme de levage (130, 136, 138, 142),
- plonger dans la couche de liquide (144) au moins des surfaces de contacts d'un composant, saisi avec la pince dans la zone d'alimentation,
- déposer le composant sur un substrat à équiper.

19. Procédé selon la revendication 18,
**caractérisé en ce que**
on règle la position d'application de telle façon qu'une épaisseur de la couche de liquide (144) à appliquer est prédéterminée, ou prédéterminable par la distance d'un bord inférieur du réservoir de liquide (120) par rapport à la surface de la plaque support de liquide (140).

20. Procédé selon la revendication 18 ou 19,
**caractérisé en ce que**
pour appliquer la couche de liquide (144), on déplace le réservoir de liquide (120) au-dessus de la plaque support de liquide (140).
